# FASCICULE DE BREVET EUROPEEN

(11) **EP 1 637 018 B1**
(45) Date de publication et mention de la délivrance du brevet: **09.07.2008**
(21) Numéro de dépôt: 04732598.0
(22) Date de dépôt: 13.05.2004
(51) Int. Cl.: H05K 5/00

(54) **BOITIER, NOTAMMENT BOITIER DESTINE A CONTENIR UN CIRCUIT IMPRIME OU SIMILAIRE ET PROCEDE POUR L'OBTENTION DE CELUI-CI**
GEHÄUSE, INSBESONDERE FÜR EINE LEITERPLATTE ODER DERGLEICHEN, SOWIE VERFAHREN ZU DESSEN HERSTELLUNG
HOUSING, ESPECIALLY HOUSING FOR CONTAINING A PRINTED CIRCUIT BOARD OR THE LIKE, AND METHOD FOR PRODUCING THE SAME

(30) Priorité: 25.06.2003 FR 0307669
(43) Date de publication de la demande: 22.03.2006
(73) Titulaire: Siemens VDO Automotive, 31036 Toulouse Cedex 1 (FR)
(72) Inventeur: BOUR, Gérard, F-78120 Rambouillet (FR)
(86) Numéro de dépôt international: PCT/EP2004/005136
(87) Numéro de publication internationale: WO 2004/114735

(56) Documents cités:
- DE-A- 3 736 986
- DE-C- 19 548 205
- DE-U- 8 705 154
- US-A1- 2002 112 870

## Description

La présente invention concerne un boîtier, notamment un boîtier destiné à contenir un circuit imprimé (appelé aussi en anglais Printed Circuit Board ou PCB) ou similaire, et un procédé pour l'obtention de celui-ci.

Il est connu, notamment dans le domaine de l'électronique, d'utiliser un boîtier à l'intérieur duquel se trouvent des composants électroniques placés sur un circuit imprimé. Ce boîtier comporte un couvercle qui peut être constitué éventuellement par le circuit imprimé. Le couvercle est vissé sur le boîtier de manière à venir fermer celui-ci de manière réversible. Un tel boîtier est connu du document US 2002/112870 A1. Souvent, les vis utilisées sont des vis générant elles-mêmes leur taraudage lors du vissage, telles que des vis autotaraudeuses ou autoformeuses. Lors de leur vissage, des copeaux sont produits et ceux-ci tombent à l'intérieur du boîtier, la vis étant introduite depuis l'extérieur de celui-ci. Les copeaux ainsi réalisés tombent parfois sur le circuit imprimé. Ils peuvent alors créer entre les pattes des composants électroniques se trouvant sur le circuit imprimé, ou entre deux pistes de ce circuit, un court-circuit. Ainsi un copeau peut rendre un dispositif électronique inutilisable.

Les composants étant maintenant implantés sur les circuits imprimés de plus en plus près les uns des autres, les problèmes de courts-circuits créés par des copeaux sont de plus en plus fréquents et deviennent donc de moins en moins admissibles. La présente invention a alors pour but de fournir un boîtier qui, par sa conception, empêche un copeau d'atteindre le circuit imprimé destiné à prendre place à l'intérieur de celui-ci. De préférence, le boîtier proposé ne présente pas de surcoût sensible par rapport à un boîtier de l'art antérieur.

A cet effet, elle propose un boîtier, notamment boîtier destiné à contenir des composants électroniques ou similaires, comportant un appui présentant un alésage pour recevoir une vis de fixation.

Selon l'invention, ce boîtier comporte en outre, face à l'alésage pour recevoir la vis, un réceptacle s'étendant à l'intérieur du boîtier.

De cette manière, les copeaux formés lors du premier vissage de la vis dans son alésage sont collectés dans le réceptacle et ne peuvent pas venir polluer les composants électroniques à l'intérieur du boîtier.

De préférence, le réceptacle s'étend depuis l'appui présentant l'alésage et forme avec cet appui, à l'exception de la zone où se trouve l'alésage, un espace fermé. Une fois la vis en place, les copeaux sont ainsi parfaitement enfermés et ne peuvent donc créer de courts-circuits au niveau des composants.

Le réceptacle est par exemple obtenu par emboutissage. Il présente, dans une forme de réalisation préférentielle, une forme générale tubulaire, de section circulaire et fermée à son extrémité opposée à l'alésage.

L'appui issu du boîtier présentant l'alésage peut se présenter sous la forme d'une languette repliée par rapport à une paroi du boîtier. Alors, avantageusement, le réceptacle est porté par une patte repliée sur la languette.

La présente invention concerne également un flan de tôle découpé et embouti, caractérisé en ce qu'il présente :
- une languette sensiblement rectangulaire, rattachée par un premier côté, sur sensiblement toute sa longueur, au reste du flan de tôle,
- un alésage réalisé dans la languette,
- une patte reliée à la languette par un côté voisin du premier côté, et
- un réceptacle obtenu par un emboutissage réalisé au niveau de la patte.

Un tel flan de tôle permet de réaliser un boîtier selon l'invention à partir d'une seule pièce de métal. Pour faciliter la réalisation du boîtier, et notamment le pliage de la patte, une découpe sensiblement rectangulaire est avantageusement prévue entre la patte et la languette de manière à former une charnière.

La présente invention propose également un procédé de réalisation d'un boîtier, dans lequel un flan de tôle est découpé puis plié, caractérisé en ce qu'il comporte les étapes suivantes :
- réalisation d'un flan de tôle tel que décrit ci-dessus,
- pliage à plat de la patte sur la languette, et
- pliage à angle droit de la languette par rapport au flan de tôle,
les deux dernières étapes pouvant être réalisées selon un ordre indifférent.

Des détails et avantages de la présente invention ressortiront mieux de la description qui suit, faite en référence au dessin schématique annexé sur lequel :
La figure 1 est une vue partielle d'un boîtier selon l'invention au niveau d'une vis de fixation,
La figure 2 est une vue en coupe selon la ligne de coupe II-II de la figure 4,
La figure 3 est une vue de face des éléments représentés sur la figure 1,
La figure 4 est une vue selon la ligne de coupe IV-IV de la figure 3,
La figure 5 est une vue de dessus de la découpe d'un flan de tôle pour obtenir la partie représentée sur la figure 1, et
La figure 6 est une vue en coupe selon une ligne de coupe VI-VI de la figure 5.

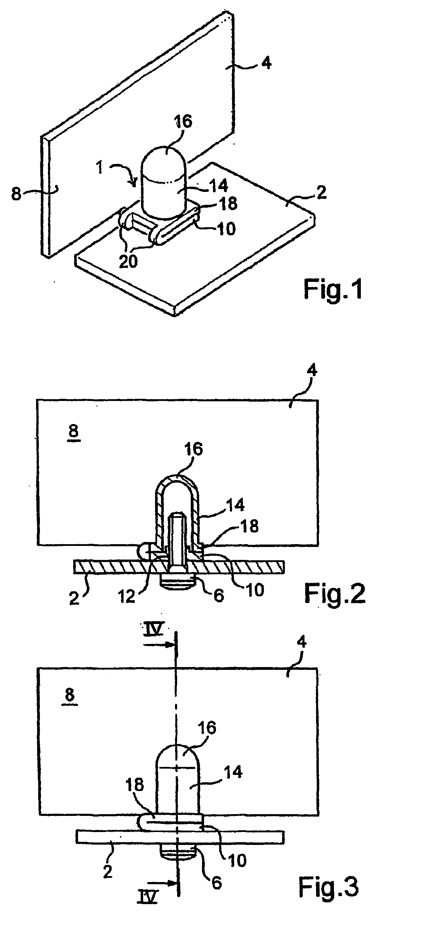

La figure 1 montre, vue de dessous, la fixation d'un couvercle 2 sur un boîtier 4. Le couvercle 2 peut être un couvercle en tôle, ou en toute autre matière, ou bien il peut également s'agir d'un circuit imprimé. Les composants fixés sur ce circuit imprimé se trouvent alors orientés vers l'intérieur du boîtier lorsque ce circuit imprimé est fixé sur le boîtier 4. Sur les figures 2 à 4, on remarque une vis 6 pour le maintien du couvercle 2 sur le boîtier 4. Il s'agit ici de préférence d'une vis autoformeuse qui permet une excellente fixation sans l'utilisation d'un écrou.

Sur les figures 1 à 4 du dessin, on voit une partie d'une paroi latérale 8 du boîtier 4. Le couvercle 2 est positionné perpendiculairement à cette paroi latérale 8. Pour permettre la fixation du couvercle 2, la paroi latérale 8 comporte une languette 10 d'une seule pièce avec la paroi latérale 8 et repliée par rapport à cette paroi à angle droit vers l'intérieur du boîtier. Dans cette languette 10 est réalisé un alésage 12 pour recevoir la vis autoformeuse 6. On prévoit, de manière connue, que cet alésage est de diamètre moindre que le diamètre de la tige de la vis 6. Ainsi, de manière connue, la vis 6 vient, lorsqu'elle est vissée dans l'alésage 12, déformer la languette 10 autour de l'alésage 12 de manière à former un taraudage dans la languette 10.

La languette 10 porte un réceptacle 14. Celui-ci est de forme sensiblement cylindrique circulaire et est tubulaire. Il s'étend perpendiculairement au plan de la languette 10 (elle-même parallèle au couvercle 2). Le réceptacle 14 repose sur la languette 10. Il est ouvert du côté de cette languette 10 et est fermé à son extrémité opposée. La paroi de fond 16, c'est à dire celle se trouvant à l'opposé de la languette 10, est par exemple de forme hémisphérique. Le bord du réceptacle, du côté de la languette 10, vient entourer l'alésage 12 réalisé dans cette languette 10. Le réceptacle 14 crée ainsi un espace fermé qui a pour seule ouverture l'alésage 12 et qui est entièrement fermé lorsqu'une vis 6 se trouve dans cet alésage.

Le réceptacle 14 est formé sur une patte 18 ne formant qu'une seule pièce avec la languette 10. Cette patte 18 est repliée à 180° par rapport à la languette 10. La patte 18 est reliée à la languette 10 par deux fines bandes de métal formant une charnière 20. Le réceptacle 14 et sa paroi de fond 16 sont par exemple obtenus par emboutissage de la patte 18.

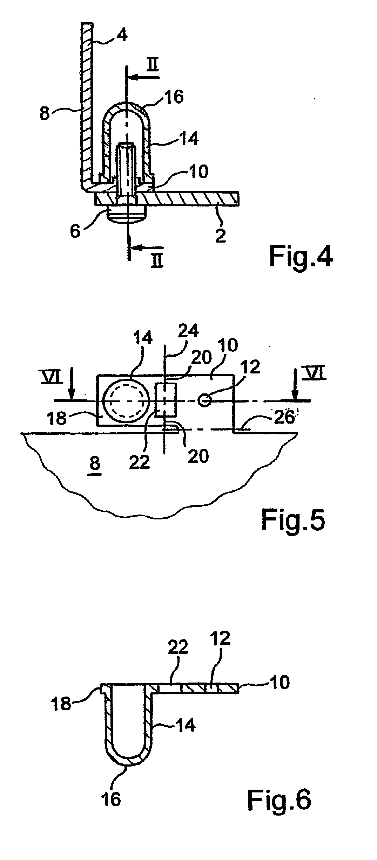

La languette 10 et le réceptacle 14 peuvent avantageusement ne former qu'une seule pièce avec la paroi 8 du boîtier 4. Par découpe, emboutissage et pliage on obtient la languette 10 pour la fixation de la vis 6 et le réceptacle 14 servant de piège à copeaux pour les copeaux produit lors du premier vissage de la vis 6 autoformeuse dans son alésage 12. La figure 5 montre après découpe et avant pliage le détail d'une tôle utilisée pour réaliser le boîtier 4 représenté sur les figures 1 à 4. On reconnaît sur cette figure 5 la paroi 8, la languette 10 dans laquelle est réalisé l'alésage 12, la patte 18 portant le réceptacle 14 et reliée à la languette 10 par la charnière 20. La languette 10 est rattachée à la paroi 8. La patte 18 est quant à elle rattachée à la paroi 8 uniquement par l'intermédiaire de la languette 10 et de la charnière 20. Pour réaliser cette dernière, le flan de tôle utilisé pour réaliser le boîtier 4 présente une découpe rectangulaire 22 séparant la languette 10 de la patte 18. L'emboutissage formant le réceptacle 14 peut être réalisé immédiatement avant la découpe de la tôle. Cette opération se fait sur une même presse avec un outil adapté. Une fois la découpe réalisée, deux pliages sont réalisés successivement. La patte 18 est repliée de 180° autour d'une premier axe de pliage 24 puis l'ensemble formé par la patte 18 et la languette 10 est plié de 90° autour d'un second axe de pliage 26 pour être rabattu vers l'intérieur du boîtier 4. On réalise ainsi, quasiment sans surcoût par rapport à un boîtier classique qui comporte une languette mais pas de patte munie d'un réceptacle, un piège à copeaux qui garantit qu'aucun copeau issu du vissage de la vis 6 dans l'alésage 12 ne vient polluer les composants électroniques se trouvant à l'intérieur du boîtier 4. On peut ainsi éviter tout problème de courts-circuits entre les pattes des composants ou les pistes du circuit imprimé. Ceci se réalise sans rajouter de nouvelles pièces et quasiment sans surcoût par rapport aux boîtiers de l'art antérieur.

La présente invention ne se limite pas à la forme de réalisation préférentielle décrite ci-dessus à titre d'exemple non limitatif. Elle concerne également toutes les variantes de réalisation à la portée de l'homme du métier dans le cadre des revendications ci-après.

Ainsi par exemple, la languette 10 et la patte 18 ne sont pas nécessairement placées sur un bord de la paroi latérale 8, mais peuvent être obtenues à tout endroit de celle-ci, en formant une découpe de ladite paroi 8 sur la périphérie de l'ensemble languette 10 et patte 18, à l'exception du coté de la languette 10 correspondant au second axe de pliage 26.

De plus, la forme du réceptacle peut être différente de celle décrite. Le procédé d'obtention peut lui aussi être différent. On peut en effet prévoir un réceptacle constitué d'une pièce distincte du boîtier. Par exemple dans le cas d'un boîtier pour la réalisation duquel des opérations de soudure sont nécessaires, on peut prévoir de venir souder une pièce au niveau d'un alésage destiné à recevoir une vis autoformeuse de manière à former le piège à copeaux.

## Revendications

1. Boîtier (4), notamment boîtier (4) destiné à contenir des composants électroniques ou similaires, comportant un appui (1) présentant un alésage (12) pour recevoir une vis de fixation (6), **caractérisé en ce qu'**il comporte en outre, face à l'alésage (12) pour recevoir la vis (6), un réceptacle (14) s'étendant à l'intérieur du boîtier.

2. Boîtier selon la revendication 1, **caractérisé en ce que** le réceptacle (14) s'étend depuis l'appui (1) présentant l'alésage (12) et forme avec cet appui (1), à l'exception de la zone où se trouve l'alésage (12), un espace fermé.

3. Boîtier selon l'une des revendications 1 ou 2, **caractérisé en ce que** le réceptacle (14) est obtenu par emboutissage.

4. Boîtier selon l'une des revendications 1 à 3, **caractérisé en ce que** le réceptacle (14) présente une forme générale tubulaire, de section circulaire et fermée à son extrémité opposée à l'alésage (12).

5. Boîtier selon l'une des revendications 1 à 4, **caractérisé en ce que** l'appui (1) présentant l'alésage (12) se présente sous la forme d'une languette (10) repliée par rapport à une paroi (8) du boîtier.

6. Boîtier selon la revendication 5, **caractérisé en ce que** le réceptacle (14) est porté par une patte (18) repliée sur la languette (10).

7. Flan de tôle découpé et embouti, **caractérisé en ce qu'**il présente :
- une languette (10) sensiblement rectangulaire, rattachée par un premier côté, sur sensiblement toute sa longueur, au reste du flan de tôle,
- un alésage (12) réalisé dans la languette (10),
- une patte (18) reliée à la languette (10) par un côté voisin du premier côté, et
- un réceptacle (14) obtenu par un emboutissage réalisé au niveau de la patte (18).

8. Flan de tôle selon la revendication 7, **caractérisé en ce qu'**il présente une découpe (22) sensiblement rectangulaire réalisée entre la patte (18) et la languette (10) de manière à former une charnière (20).

9. Procédé de réalisation d'un boîtier 4, dans lequel un flan de tôle est découpé puis plié, **caractérisé en ce qu'**il comporte les étapes suivantes :
- réalisation d'un flan de tôle selon l'une des revendications 7 ou 8,
- pliage à plat de la patte (18) sur la languette (10), et
- pliage à angle droit de la languette (10) par rapport au flan de tôle,
les deux dernières étapes pouvant être réalisées selon un ordre indifférent.

## Claims

1. Housing (4), in particular a housing (4) intended to contain electronic components or the like, comprising a support (1) having a bore (12) for receiving a fixing screw (6), **characterised in that** it additionally comprises, facing the bore (12) for receiving the screw (6), a receptacle (14) extending inside the housing.

2. Housing according to claim 1, **characterised in that** the receptacle (14) extends from the support (1) having the bore (12) and, with the exception of the region in which the bore (12) is situated, forms a closed space with this support (1).

3. Housing according to claim 1 or claim 2, **characterised in that** the receptacle (14) is obtained by stamping.

4. Housing according to one of claims 1 to 3, **characterised in that** the receptacle (14) has a generally tubular shape of circular cross section which is closed at its end opposed to the bore (12).

5. Housing according to one of claims 1 to 4, **characterised in that** the support (1) having the bore (12) takes the form of a lug (10) folded over with respect to a wall (8) of the housing.

6. Housing according to claim 5, **characterised in that** the receptacle (14) is borne by a tab (18) folded over onto the lug (10).

7. Cut and stamped sheet-metal blank, **characterised in that** it has:
- a substantially rectangular lug (10) attached by a first side, substantially over its entire length, to the remainder of the sheet-metal blank,
- a bore (12) made in the lug (10),
- a tab (18) connected to the lug (10) by a side in the vicinity of the first side, and
- a receptacle (14) obtained by a stamping operation performed on the tab (18).

8. Sheet-metal blank according to claim 7, **characterised in that** it has a substantially rectangular cut-out (22) produced between the tab (18) and the lug (10) so as to form a hinge (20).

9. Process for producing a housing 4, in which a sheet-metal blank is cut and then folded, **characterised in that** it comprises the steps which follow:
- production of a sheet-metal blank according to claim 7 or 8,
- folding the tab (18) flat onto the lug (10), and
- folding the lug (10) at a right angle with respect to the sheet-metal blank, it being possible for the last two steps to be carried out in whatever order.

## Patentansprüche

1. Gehäuse (4), insbesondere ein Gehäuse (4) für elektronische Bauelemente oder dergleichen, das eine Auflage (1) umfasst, die eine Bohrung (12) zur Aufnahme einer Befestigungsschraube (6) aufweist, **dadurch gekennzeichnet, dass** es außerdem gegenüber der Bohrung (12) zur Aufnahme der Schraube (6) eine Aufnahme (14) umfasst, die sich im Inneren des Gehäuses erstreckt.

2. Gehäuse nach Anspruch 1, **dadurch gekennzeichnet, dass** die Aufnahme (14) sich von der Auflage (1) aus erstreckt, die die Bohrung (12) umfasst, und mit dieser Auflage (1) mit Ausnahme des Bereichs, in dem sich die Bohrung (12) befindet, einen geschlossenen Raum bildet.

3. Gehäuse nach einem der Ansprüche 1 oder 2, **dadurch gekennzeichnet, dass** die Aufnahme (14) durch Tiefziehen erhalten wird.

4. Gehäuse nach einem der Ansprüche 1 bis 3, **dadurch gekennzeichnet, dass** die Aufnahme (14) insgesamt röhrenförmig mit kreisförmigem Querschnitt ist, und an ihrem Ende gegenüber der Bohrung (12) geschlossen ist.

5. Gehäuse nach einem der Ansprüche 1 bis 4, **dadurch gekennzeichnet, dass** die Auflage (1), die die Bohrung (12) aufweist, in Form einer Zunge (10) auftritt, die in Bezug auf eine Wand (8) des Gehäuses umgebogen ist.

6. Gehäuse nach Anspruch 5, **dadurch gekennzeichnet, dass** die Aufnahme (14) von einer Lasche (18) getragen wird, die auf der Zunge (10) umgebogen ist.

7. Geschnittene und tiefgezogene Blechscheibe, **dadurch gekennzeichnet, dass** sie umfasst:
- eine im Wesentlichen rechteckige Zunge (10), die durch eine erste Seite auf im Wesentlichen ihrer gesamten Länge an der übrigen Blechscheibe befestigt ist,
- eine Bohrung (12), die in der Zunge (10) ausgeführt ist,
- eine Lasche (18), die mit der Zunge (10) durch eine benachbarte Seite der ersten Seite verbunden ist, und
- eine Aufnahme (14), die durch Tiefziehen erhalten wird, das im Bereich der Lasche (18) ausgeführt wird.

8. Blechscheibe nach Anspruch 7, **dadurch gekennzeichnet, dass** sie einen im Wesentlichen rechteckigen Zuschnitt (22) aufweist, der zwischen der Lasche (18) und der Zunge (10) ausgeführt ist, so dass er ein Scharnier (20) bildet.

9. Verfahren zur Herstellung eines Gehäuses 4, in dem eine Blechscheibe geschnitten und anschließend gebogen wird, **dadurch gekennzeichnet, dass** es die folgenden Schritte umfasst:
- Ausführen einer Blechscheibe nach einem der Ansprüche 7 oder 8,
- Flachbiegen der Lasche (18) auf der Zunge (10), und
- Biegen der Zunge (10) im rechten Winkel in Bezug auf die Blechscheibe,
wobei die zwei letzten Schritte in einer beliebigen Reihenfolge ausgeführt werden können.
